# FASCICULE DE BREVET EUROPEEN

(11) **EP 3 134 924 B1**
(45) Date de publication et mention de la délivrance du brevet: **16.05.2018**
(21) Numéro de dépôt: 15720629.3
(22) Date de dépôt: 20.04.2015
(51) Int. Cl.: H01L 33/18, H01L 33/12, H01L 33/00, H01L 33/08, H01L 33/46

(54) **DISPOSITIF OPTOÉLECTRONIQUE À RENDEMENT D'EXTRACTION LUMINEUSE AMÉLIORÉ ET SON PROCÉDÉ DE FABRICATION**
OPTOELEKTRONISCHE VORRICHTUNG MIT VERBESSERTER LICHTAUSKOPPLUNGSEFFIZIENZ UND HERSTELLUNGSVERFAHREN DAFÜR
OPTOELECTRONIC DEVICE WITH IMPROVED LIGHT EXTRACTION EFFICIENCY AND METHOD FOR MANUFACTURING THE SAME.

(30) Priorité: 22.04.2014 FR 1453608
(43) Date de publication de la demande: 01.03.2017
(73) Titulaire: Commissariat à l'Énergie Atomique et aux Énergies Alternatives, 75015 Paris (FR); Aledia, 38000 Grenoble (FR)
(72) Inventeur: HYOT, Bérangère, F-38320 Eybens (FR); DUPONT, Florian, F-38000 Grenoble (FR)
(74) Mandataire: Novaimo
(86) Numéro de dépôt international: PCT/EP2015/058483
(87) Numéro de publication internationale: WO 2015/162080

(56) Documents cités:
- WO-A1-2011/162715
- FR-A1- 2 984 599

## Description

### Domaine technique de l'invention

L'invention concerne le domaine de l'optoélectronique.

L'invention a pour objet plus particulièrement un dispositif optoélectronique comprenant un substrat, un organe, notamment semiconducteur, émetteur de lumière comportant un élément allongé dans une direction formant un angle avec le substrat, notamment de type microfil ou nanofil, un élément intermédiaire interposé entre le substrat et une extrémité longitudinale de l'élément allongé la plus proche du substrat.

### État de la technique

Un dispositif optoélectronique est adapté à la conversion d'un signal électrique en lumière, ou rayonnement électromagnétique, notamment en vue de l'émettre.

Dans le cadre de la réalisation d'un organe émetteur de lumière du dispositif optoélectronique, il est connu d'utiliser des nanofils ou microfils comprenant un matériau semi-conducteur comportant au moins un élément du groupe III et un élément du groupe V de la classification périodique des éléments. Ce nanofil est utilisé de sorte à participer à la formation d'une jonction P-N destinée à émettre la lumière.

Lors de la génération de la lumière à émettre, un observateur voit la lumière émise qui s'échappe du dispositif optoélectronique. Toutefois, une partie de la lumière émise est absorbée par des portions du dispositif optoélectronique comme, par exemple, le substrat supportant l'organe émetteur de lumière, ou encore les éléments allongés eux mêmes.

Il en résulte que le rendement du dispositif optoélectronique n'est pas optimisé.

En ce sens, il existe une problématique quant à l'augmentation de la lumière effectivement restituée par le dispositif optoélectronique, et donc perçue par l'observateur.

Les documents FR 2984599 A1 et WO 2011/162715 A1 divulguent des dispositifs optoélectroniques comportant des éléments allongés comme émetteurs de lumière.

### Objet de l'invention

Le but de la présente invention est de proposer une solution permettant d'améliorer le rendement d'extraction lumineuse du dispositif optoélectronique.

On tend vers ce but notamment en ce que le substrat est transparent à ladite lumière, et en ce que l'élément intermédiaire, transparent à ladite lumière, comporte au moins un nitrure d'un métal de transition, et présente une épaisseur inférieure ou égale à 9nm.

De préférence, le substrat est électriquement isolant et/ou l'élément intermédiaire est configuré de sorte à participer à l'injection de porteurs de charge dans l'élément allongé en vue d'émettre ladite lumière.

Avantageusement, le métal de transition est choisi parmi : le titane, le vanadium, le chrome, le zirconium, le niobium, molybdène, l'hafnium, le tantale, ou une combinaison de ces derniers.

Préférentiellement, le substrat est en verre d'oxyde, notamment en verre silicaté à base de SiO₂.

Selon une réalisation, le dispositif comporte une zone de restitution de ladite lumière et un miroir agencé de manière à orienter au moins une partie de ladite lumière issue de l'organe émetteur de lumière en direction de ladite zone de restitution.

Selon une mise en oeuvre, le dispositif comporte une pluralité d'organes émetteurs de lumière comportant chacun un élément allongé, et l'élément intermédiaire forme une couche commune associée à chacun des éléments allongés, ou en chacun des éléments allongés est associé à un élément intermédiaire correspondant, se présentant sous la forme d'un plot, qui lui est propre.

L'invention est aussi relative à un procédé de fabrication d'un dispositif optoélectronique tel que décrit, le procédé de fabrication comportant les étapes suivantes :
- une fourniture du substrat transparent à ladite lumière,
- une formation de l'élément intermédiaire de telle sorte à ce qu'il soit transparent à ladite lumière et qu'il présente une surface de croissance de l'élément allongé, l'élément intermédiaire comportant au moins un nitrure d'un métal de transition et présentant une épaisseur inférieure ou égale à 9 nm,
- une formation de l'organe émetteur de lumière comprenant une étape de croissance de l'élément allongé à partir de la surface de croissance.

De préférence, ledit élément intermédiaire étant formé par un nitrure d'un métal de transition, l'étape de formation de l'élément intermédiaire comporte une étape de dépôt dudit élément intermédiaire à partir d'un mélange gazeux comprenant de l'azote et le métal de transition.

Avantageusement, l'étape de formation de l'élément intermédiaire comporte :
- une étape de dépôt, notamment sur le substrat ou sur une couche d'un oxyde transparent conducteur formée sur le substrat, d'une couche du métal de transition, notamment choisi parmi Ti, V, Cr, Zr, Nb, Mo, Hf, Ta,
- une étape de nitruration d'au moins une partie de la couche de métal de transition.

Selon une première réalisation, l'étape de nitruration comporte :
- une première sous-étape de nitruration réalisée au moins en partie à une première température en imposant une injection d'un gaz de nitruration selon un premier débit,
- une deuxième sous-étape de nitruration réalisée au moins en partie à une deuxième température inférieure ou égale à la première température en imposant une injection du gaz de nitruration selon un deuxième débit distinct, ou non, du premier débit.

De préférence, selon cette première réalisation, le gaz de nitruration injecté est de l'ammoniac, et :
- la première température est comprise entre 1000°C et 1050°C, notamment égale à 1050°C,
- le premier débit est compris entre 500*V/8 sccm et 2500*V/8 sccm, notamment égal à 1600*V/8sccm,
- la deuxième température est comprise entre 950°C et 1050°C, notamment égale à 1000°C,
- le deuxième débit est compris entre 500*V/8 sccm et 2500*V/8 sccm, notamment égal à 500*V/8 sccm
où V est la capacité totale en litre d'une enceinte de nitruration correspondante.

Selon une deuxième réalisation, l'étape de nitruration comporte :
- une première sous-étape de nitruration réalisée au moins en partie à une première température en imposant une injection d'un gaz de nitruration selon un premier débit,
- une deuxième sous-étape de nitruration réalisée au moins en partie à une deuxième température supérieure ou égale à la première température en imposant une injection du gaz de nitruration selon un deuxième débit distinct, ou non, du premier débit.

Selon cette deuxième réalisation, le gaz de nitruration injecté est de l'ammoniac, et :
- la première température est comprise entre 400°C et 1400°C,
- le premier débit est compris entre 10*V/18 sccm et 4000*V/18 sccm, notamment égal à 1200*V/18 sccm,
- la deuxième température est comprise entre 400°C et 1400°C,
- le deuxième débit est compris entre 10*V/18 sccm et 4000*V/18 sccm, notamment égal à 1200*V/18 sccm
où V est la capacité totale en litre d'une enceinte de nitruration correspondante.

Préférentiellement, l'étape de nitruration est réalisée dans une enceinte de nitruration placée à une pression comprise entre 50 mbar et 800 mbar, notamment 100 mbar.

Avantageusement, l'étape de croissance de l'élément allongé est réalisée après la deuxième sous-étape de nitruration, ou est initiée au cours de la deuxième sous-étape de nitruration.

De préférence, l'étape de croissance de l'élément allongé comporte une étape d'injection de Ga de sorte à le former en nitrure de gallium, ledit élément allongé s'étendant à partir de la surface de croissance correspondante.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- les figures 1 et 2 illustrent, selon une vue en coupe, deux réalisations différentes de l'invention,
- les figures 3 à 6 illustrent, selon un vue en coupe, des perfectionnements mettant en oeuvre un miroir pour augmenter la lumière restituée,
- la figure 7 illustre une variante dans laquelle une couche d'un oxyde conducteur transparent est intercalée entre l'élément intermédiaire et le substrat,
- les figures 8 et 9 illustrent deux étapes d'un procédé de fabrication du dispositif optoélectronique,
- les figures 10 à 12 illustrent des réalisations d'une étape de nitruration du procédé de fabrication,
- la figure 13 illustre des courbes de transparence et d'absorption en fonction de l'épaisseur d'une couche de nitrure de niobium,
- les figures 14 à 16 illustrent l'utilisation d'un masque pour la croissance d'un ou plusieurs éléments allongés.

### Description de modes préférentiels de l'invention

Pour les besoins de la présente description, certains termes sont tout d'abord définis.

Dans la présente description, la notion de « sensiblement » signifie exactement ou à 10% près.

Par « lumière », on entend dans la présente description une onde, ou un rayonnement, électromagnétique. Cette lumière est associée à une longueur d'onde prédéterminée. Le domaine spectral de l'émission de la lumière pourra couvrir une large gamme de longueurs d'onde allant de l'ultraviolet à l'infrarouge. Notamment, la longueur d'onde prédéterminée est comprise entre 300 nm et 1000 nm.

Par « élément allongé », on entend un élément tridimensionnel dont l'allongement est tel qu'il définit une dimension longitudinale entre deux extrémités longitudinales opposées, et une ou des dimensions latérales définies selon une section associée à un plan de coupe sensiblement perpendiculaire à la direction de l'allongement dudit élément allongé.

Selon une réalisation particulière, l'élément allongé est un « nanofil » ou « microfil ».

Dans la suite de la description, chaque occurrence du terme « fil » peut être remplacé indifféremment par le terme « élément allongé ».

Le terme "microfil" ou "nanofil" désigne une structure tridimensionnelle de forme allongée selon une direction privilégiée dont au moins une dimension, appelée dimension latérale, est comprise entre 5 nm et 10 µm, de préférence entre 50 nm et 2,5 µm. Une dimension longitudinale est quant à elle au moins égale, ou supérieure, à 1 fois, de préférence au moins 5 fois et encore plus préférentiellement au moins 10 fois, la plus grande des dimensions latérales. Dans certains modes de réalisation, les dimensions latérales peuvent être inférieures ou égales à environ 10 µm, de préférence comprises entre 100 nm et 5 µm, plus préférentiellement entre 100 nm et 500 nm et encore plus préférentiellement entre 100 nm et 300 nm. Dans certains modes de réalisation, la hauteur (c'est-à-dire la dimension longitudinale) de chaque microfil ou nanofil peut être supérieure ou égale à 500 nm, de préférence comprise entre 1 µm et 50 µm.

Par « transparence à la lumière », on entend que lorsque tout ou partie de la lumière traverse ou se déplace dans un élément particulier (un substrat, ou le fil dans l'exemple ci-dessous), au moins 50% et préférentiellement au moins 70% n'est pas absorbé par ledit élément particulier et peut être restitué. En optique, la transmittance d'un matériau est la fraction du flux lumineux le traversant. Elle est également nommée facteur de transmission mais aussi transparence.

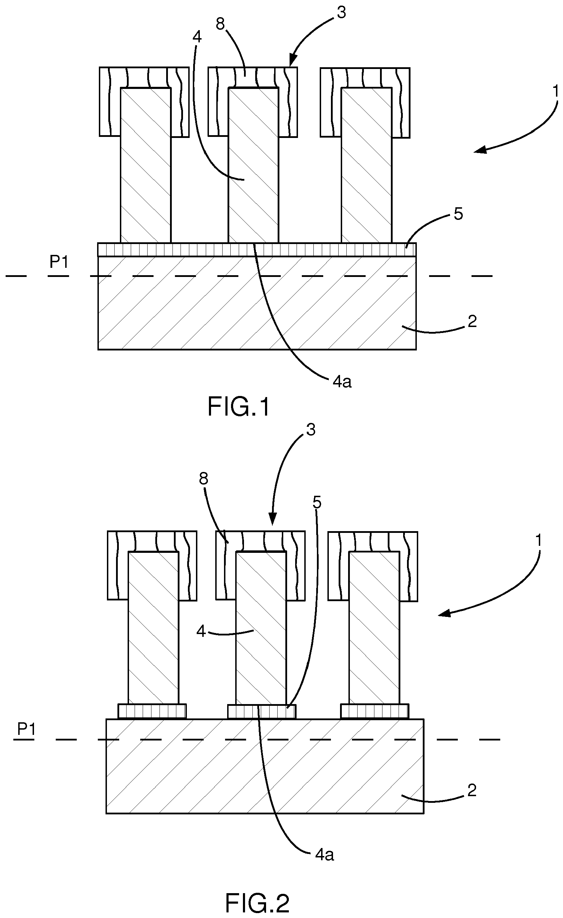

Comme illustré aux figures 1 et 2, un dispositif optoélectronique 1 comprend un substrat 2 et un organe émetteur 3 de lumière comportant un fil 4 dans une direction formant un angle avec le substrat 2.

Par « direction formant un angle avec le substrat 2 », on entend que cet angle est non nul. Autrement dit, l'allongement du fil 4 est tel que ce dernier s'étend entre des première et deuxième extrémités longitudinales opposées, ladite première extrémité longitudinale étant plus proche du substrat 2 que la deuxième extrémité longitudinale.

En particulier, le fil 4 est sensiblement vertical dans le référentiel lié au substrat 2. Lorsque l'on parle du référentiel lié au substrat 2, on entend que le plan du substrat P1 est un plan dit « horizontal » quelle que soit la position du dispositif optoélectronique dans le référentiel terrestre. Autrement dit, le fil 4 est sensiblement perpendiculaire au plan P1 du substrat 2.

Le dispositif comporte en outre un élément intermédiaire 5 interposé entre le substrat 2 et une extrémité longitudinale 4a du fil 4 la plus proche du substrat 2. Le substrat 2 est transparent à ladite lumière. L'élément intermédiaire 5, transparent à ladite lumière, comporte au moins un nitrure d'un métal de transition, et présente une épaisseur inférieure ou égale à 9nm, et de préférence inférieure ou égale à 7nm. Cette épaisseur est plus particulièrement comprise 3nm et 5nm bornes incluses.

De manière générale applicable à toutes les réalisations décrites, l'élément intermédiaire 5 peut présenter une épaisseur supérieure ou égale à 3nm.

L'épaisseur de l'élément intermédiaire 5 est donnée selon une direction sensiblement perpendiculaire au plan du substrat 2. Typiquement, le substrat 2 comporte une face de travail sur laquelle l'élément intermédiaire 5 est préférentiellement directement en contact, ou avec interposition d'un matériau ayant une fonction particulière. L'épaisseur est, dans ce cas, selon la direction du vecteur normal à la face de travail.

L'épaisseur de l'élément intermédiaire 5, telle que décrite ci-dessus, lui confère une transparence à ladite lumière.

De préférence, l'élément intermédiaire 5 est en contact direct avec le fil 4. Il en résulte qu'une partie de la lumière se propageant dans le fil 4 lors du fonctionnement du dispositif optoélectronique peut traverser l'élément intermédiaire 5 au niveau de son interface avec ledit fil 4.

Pour être transparent, le substrat 2 est préférentiellement réalisé en GaN dopé, en ZnO dopé si l'on cherche que ce dernier ait aussi des propriétés de conducteur électrique ou dans le cas d'un substrat 2 électriquement isolant il peut être en verre d'oxyde, en quartz synthétique, en Al₂O₃, en AIN, en BN, en diamant, (ces cinq derniers matériaux sont des solides cristallins)...

Par verre d'oxyde, on entend verre à base de SiO₂ (verres silicatés) ou verre à base de B₂O₃ (verre de borates) ou verre à base de P₂O₅ (verre de phosphates) ou verre associant ces différentes bases d'oxyde. Ces matériaux sont des solides non cristallins.

Dès lors, la transparence conférée au substrat 2 et à l'élément intermédiaire 5 permet d'éviter à ces « composants » d'absorber la lumière, augmentant ainsi la quantité de lumière apte à être restituée par le dispositif optoélectronique à un observateur.

En outre, l'élément intermédiaire 5 est aussi préférentiellement électriquement conducteur. En ce sens, l'élément intermédiaire 5 est configuré de sorte à participer à l'injection de porteurs de charge (électron ou trous) dans le fil 4 en vue d'émettre ladite lumière.

On a compris de ce qui a été dit ci-dessus que le substrat 2 peut être électriquement isolant ou conducteur, dans ce dernier cas, il peut participer, via l'élément intermédiaire 5 à l'injection de porteurs de charge dans le fil 4.

L'invention ne se limite bien entendu pas à un unique organe émetteur de lumière 3. Tout ce qui est dit dans la présente description concernant un organe émetteur de lumière 3 peut être appliqué à une pluralité d'organes émetteurs de lumière 3. En ce sens, comme l'illustre les figures 1 et 2, le dispositif optoélectronique 1 peut comporter une pluralité d'organes émetteurs de lumière 3 chacun comportant un fil 4. Dans le cadre de la réalisation de la figure 1, l'élément intermédiaire 5 forme une couche commune associée à chacun des fils 4. Autrement dit, les fils 4 de tous les organes émetteurs de lumière 3 s'étendent à partir d'un même élément intermédiaire 5 se présentant sous la forme d'une couche recouvrant tout ou partie d'une face du substrat 2 (dans l'exemple de la figure 1, tous les fils 4 sont directement en contact- notamment physique et électrique - avec un même élément intermédiaire).

Alternativement, chacun des fils 4 est associé à un élément intermédiaire 5 correspondant, se présentant sous la forme d'un plot, qui lui est propre (figure 2). Autrement dit, le dispositif optoélectronique comporte une pluralité d'éléments intermédiaires 5, et chaque élément intermédiaire 5 forme un plot à partir duquel s'étend un seul fil 4 d'un organe émetteur de lumière 3 correspondant. La réalisation de la figure 2 demande usuellement plus d'étapes technologiques, cependant il résulte que l'utilisation de moins de métal de transition (nitruré) limite l'absorption générale de la lumière émise notamment entre deux organes émetteurs de lumière 3.

Outre les caractéristiques de l'élément intermédiaire 5 décrites ci-dessus, le nitrure de métal de transition permet aussi avantageusement de faciliter la croissance du fil 4 lors de la fabrication du dispositif optoélectronique. Il en résulte que la présence de l'élément intermédiaire 5 permet à la fois une croissance sensiblement verticale par rapport au substrat 2 et une croissance avec une densité élevée. Ce point sera détaillé ci-après.

De manière préférentielle, le métal de transition est choisi parmi : le titane, le vanadium, le chrome, le zirconium, le niobium, le molybdène, l'hafnium, le tantale, ou une combinaison de ces derniers. Le nitrure de ces derniers permet, dans l'épaisseur considérée de l'élément intermédiaire 5, une transparence élevée et une faible résistivité électrique intrinsèque permettant une injection de courant (porteurs de charge) par la base du fil 4 formée par l'extrémité longitudinale 4a du fil 4 la plus proche du substrat 2.

Le nitrure de niobium est particulièrement avantageux dans le sens où il présente une résistivité de 58µΩ.cm. C'est donc un excellent conducteur électrique.

L'organe émetteur de lumière 3 est préférentiellement une diode électroluminescente (DEL) comportant une jonction P-N. Dans ce cadre, le fil 4 peut constituer la jonction (il comporte alors un premier tronçon dopé N et un deuxième tronçon dopé P placé dans la continuité du premier tronçon). Plus précisément la partie inférieure du fil (proximale de la couche intermédiaire) est dopé n puis une coquille de matériau dopé p est ensuite déposée sur le partie supérieure du fil (distale de la couche intermédiaire). Ainsi, des porteurs de charge d'un premier type peuvent être injectés par l'élément intermédiaire 5 dans le fil 4 via l'extrémité longitudinale 4a dudit fil 4 le plus proche du substrat 2, et des porteurs de charge d'un second type peuvent être injectés dans l'organe émetteur dans une zone située à distance du substrat 2. La recombinaison de ces porteurs de charge du premier type et du deuxième type génère alors des photons constituant ladite lumière émise. Selon le mode d'exécution visible aux figures 1 à 4 et 6, le fil 4 est formé dans un matériau semiconducteur dopé d'un premier type et le dispositif optoélectronique comporte un élément additionnel semiconducteur 8 (formant préférentiellement la coquille décrite ci-dessus) dopé d'un deuxième type opposé au premier type de sorte à former la jonction P-N (on comprend alors que les premier et deuxième types de dopage sont choisis entre un dopage P ou un dopage N). Préférentiellement, l'élément additionnel 8 forme une coquille, ou fourreau, autour du fil 4. Pour améliorer le rendement de l'organe émetteur 3 de lumière, des puits quantiques sont préférentiellement interposés entre le fil 4 et l'élément additionnel 8 (non représentés aux figures).

La jonction P-N peut être une homojonction ou une hétérojonction.

Autrement dit, on comprend que de manière générale, l'organe émetteur de lumière 3 comporte une première partie dopée d'un premier type (P ou N) et une deuxième partie dopée d'un deuxième type (N ou P) opposé au premier type, ledit fil 4 formant en tout ou partie la première partie de l'organe émetteur de lumière 3. L'association des première et deuxième parties de l'organe émetteur de lumière 3 formant la jonction P-N.

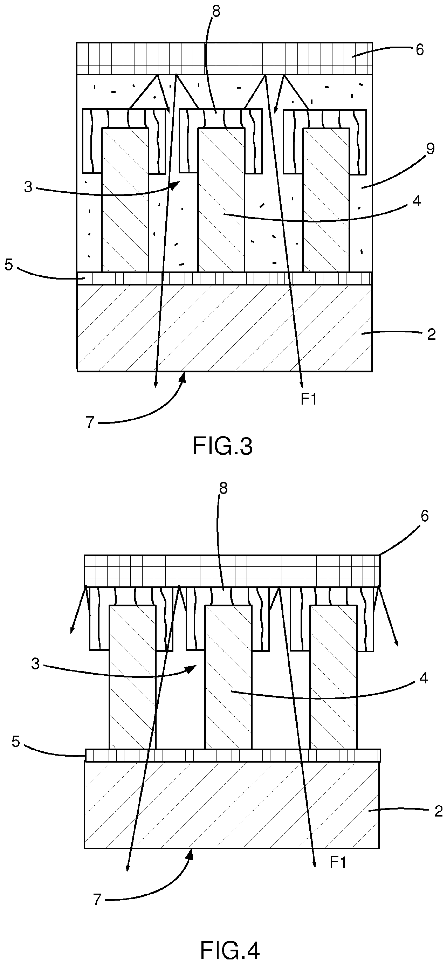

Grâce à l'utilisation d'un élément intermédiaire 5 et d'un substrat 2 tels que décrits, on a évoqué précédemment que l'on limitait l'absorption de photons par le dispositif optoélectronique lui-même. Cette absorption étant limitée, il reste à maximiser la restitution de la lumière à l'extérieur du dispositif optoélectronique, notamment en direction de l'observateur. En ce sens, le dispositif optoélectronique comprend préférentiellement un ou plusieurs miroirs. Autrement dit, le dispositif optoélectronique comporte une zone de restitution 7 de la lumière et un miroir 6 agencé de manière à orienter au moins une partie (F1) de la lumière issue du ou des organes émetteurs de lumière 3 en direction de la zone de restitution 7 (figures 3 à 6). En fait, on comprend ici que l'organe émetteur de lumière 3 génère ladite lumière et l'émet de manière multidirectionnelle. En ce sens, on va chercher à récupérer des photons de ladite lumière dont le déplacement est orienté dans une direction contraire à la zone de restitution 7, et à les diriger volontairement vers ladite zone de restitution 7.

Selon un premier mode de réalisation utilisant un miroir illustré aux figures 3 à 5, l'organe émetteur 3 de lumière est interposé, notamment en tout ou partie, entre le miroir 6 et le substrat 2. Les flèches partant des organes émetteurs de lumière 3 schématisent le cheminement d'un photon de la lumière émise. On comprend ici que la zone de restitution 7 est proximale du substrat 2 et que la lumière est extraite/restituée par le substrat 2 transparent. Plus particulièrement, la zone de restitution 7 est disposée ou constituée par la face du substrat 2 opposée à celle en regard de, ou en contact de, l'élément intermédiaire 5.

Selon une première variante du premier mode de réalisation utilisant un miroir illustrée en figure 3, le miroir 6 est tenu à distance des organes émetteurs de lumière 3, notamment par interposition d'un matériau isolant transparent 9 par exemple du SiO₂ ou du SiN. Le miroir 6 peut être formé en argent ou en aluminium, ou alternativement être un miroir de Bragg comportant une alternance de couches isolantes électriquement comme le SiN ou le SiO₂ pour assurer une réflectivité suffisante dans le domaine de la longueur d'onde de la lumière émise par le ou les organes émetteurs. Dans cette première variante, bien que cela ne soit pas représenté, une injection de porteurs de charge est avantageusement réalisée à l'opposé de l'extrémité longitudinale dudit fil 4 la plus proche du substrat 2 ou sur le flanc latéral des fils, cette injection peut être mise en oeuvre par une couche d'un matériau transparent conducteur par exemple de type TCO.

Selon une deuxième variante du premier mode de réalisation utilisant un miroir, le miroir 6 peut être métallique (par exemple en argent), et dans ce cas il peut être avantageusement en contact électrique avec l'organe émetteur 3 de lumière (figure 4) de sorte à permettre l'injection de porteurs de charge destinés à participer à la génération de la lumière émise. L'utilisation du miroir 6 pour injecter des porteurs de charge permet d'améliorer le rendement quantique interne du dispositif optoélectronique par rapport à l'utilisation du matériau transparent conducteur TCO de la première variante du premier mode de réalisation utilisant un miroir.

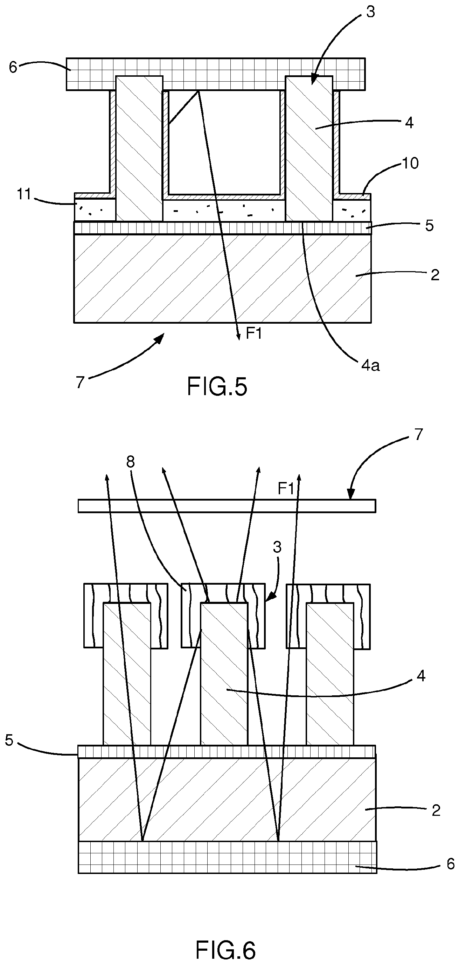

Selon une troisième variante du premier mode de réalisation utilisant un miroir illustrée en figure 5, le miroir 6 est en contact avec l'organe émetteur 3 émetteur de lumière à distance du substrat 2 et les flancs latéraux d'une portion de l'organe émetteur 3 de lumière (ici le fil 4) dopée du deuxième type et disposés entre le miroir 6 et le substrat 2 sont recouverts par une couche d'injection de porteurs de charge 10 en matériau transparent conducteur (TCO de préférence). Dans ce cas, l'élément intermédiaire 5 permet l'injection de porteurs de charge dans une portion de l'organe émetteur 3 dopée du premier type opposé au deuxième type et incluant l'extrémité longitudinale 4a du fil 4 la plus proche du substrat 2. Ici, tout comme dans la deuxième variante, le miroir 6 peut aussi participer à l'injection de porteurs de charge. Cette architecture a pour avantage de combiner un bon contact électrique sur le matériau dopé (notamment dopé P) avec une surface par laquelle les photons peuvent s'échapper. A la figure 5, un masque 11 ayant servit à la croissance du fil 4 est avantageusement utilisé pour éviter le court-circuit entre la couche 10 et l'élément intermédiaire 5. Ce masque 11 est donc préférentiellement électriquement isolant.

Dans le cadre des deux premières variantes du premier mode de réalisation (figures 3 et 4), la référence 11 représente aussi un masque ayant servi à la croissance du fil 4.

Selon une deuxième mise en oeuvre utilisant un miroir illustrée à la figure 6, le miroir 6 est disposé au niveau d'une face du substrat 2 opposée à la face dudit substrat 2 en regard de, ou en contact avec, l'élément intermédiaire 5. Dans ce cas, l'organe émetteur 3, lorsqu'il fonctionne, émet la lumière de telle manière qu'au moins une partie est émise vers la zone de restitution 7 (flèche F1) et une autre partie en direction du substrat 2. Ladite autre partie traverse alors successivement l'élément intermédiaire 5, le substrat 2, puis viens se réfléchir sur le miroir 6 de sorte à repartir vers la zone de restitution 7. Le cheminement de la lumière est schématisé par des flèches partant de l'organe émetteur 3. Ici encore, le miroir 6 peut être en aluminium ou être formé par un miroir de Bragg tel que décrit précédemment.

Le fil 4 peut comporter, ou être constitué par, un matériau semiconducteur comportant au moins un élément du groupe III et un élément du groupe V (préférentiellement un nitrure d'un élément du groupe III) de la classification périodique des éléments.

Avantageusement, le ou les fils 4 sont en nitrure de gallium. Le nitrure de gallium est un bon candidat pour former un dispositif optoélectronique.

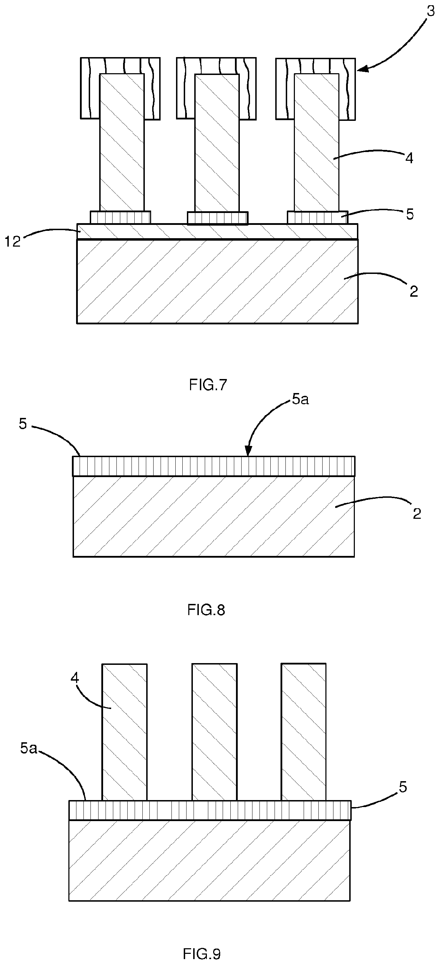

Selon un perfectionnement illustré en figure 7 et applicable à toutes les réalisations décrites ci-avant (mais d'autant plus valable lorsque le substrat est électriquement isolant), il est cherché à améliorer la conductivité électrique de l'élément intermédiaire 5 (préférentiellement de chaque élément intermédiaire). En ce sens, le dispositif optoélectronique peut comporter une couche de conduction électrique 12 en un matériau transparent et conducteur électrique par exemple du TCO (pour l'anglais « Transparent Conductive Oxide »). Cette couche de conduction 12 est interposée entre le substrat 2 et l'élément intermédiaire 5. Lorsque le dispositif optoélectronique comporte une pluralité d'organes émetteurs 3 chacun associé à un élément intermédiaire 5 distinct, cette couche de conduction 12 présente aussi l'avantage de mutualiser l'injection de porteurs de charge dans tous les fils 4 des organes émetteurs 3 de lumière via les éléments intermédiaires 5 correspondants.

La couche de conduction électrique 12 peut présenter une épaisseur (selon la normale à la face du substrat sur laquelle elle est formée) dont l'épaisseur varie de 1nm à 1000nm, et est préférentiellement égale à 50nm. Dans ce cas précis des 50nm, la connexion électrique de la ou des extrémités longitudinales des fils 4 les plus proches du substrat 2 sera assurée avec une absorption optique de la structure inférieure à 5%, on parle ici de l'absorption optique introduite par la couche de conduction électrique préférentiellement en TCO.

L'invention est aussi relative à un procédé de fabrication du dispositif tel que décrit précédemment.

Le procédé de fabrication du dispositif optoélectronique comporte les étapes suivantes :
- une fourniture du substrat 2 transparent à ladite lumière (figure 8),
- une formation de l'élément intermédiaire 5 d'épaisseur inférieure ou égale à 9nm, de préférence inférieure ou égale à 7nm et notamment comprise entre 3nm et 5nm bornes incluses, de telle sorte qu'il soit transparent à ladite lumière et de telle sorte qu'il présente une surface de croissance 5a du fil 4,
- une formation de l'organe émetteur 3 de lumière comprenant une étape de croissance du fil 4 (figure 9) à partir de la surface de croissance 5a.

On comprend alors que l'élément intermédiaire 5 sert donc d'élément de germination/nucléation permettant la croissance du fil 4. Outre les propriétés de l'élément intermédiaire 5 dans le cadre du dispositif optoélectronique terminé, il s'avère que dans le cadre d'un substrat transparent, notamment en verre d'oxyde (notamment en verre silicaté à base de SiO₂), cette épaisseur inférieure à 9nm, formée directement sur ledit substrat 2, permet d'obtenir un fil 4 dont la verticalité est satisfaisante. Dans le cadre de la présente invention, il s'avère que plus on augmente l'épaisseur de l'élément intermédiaire 5 déposé sur le substrat 2, plus les fils 4 se forment de manière anarchique et non adaptée à une fonctionnalisation du fil 4 en vue de former l'organe émetteur de lumière 3. En outre, l'élément intermédiaire 5 tel que décrit présente une structure cristallographique propice à la croissance dudit fil.

Ce phénomène est tout particulièrement exacerbé lorsque le procédé de fabrication utilise les paramètres suivants : le substrat 2 est en verre d'oxyde (notamment en verre silicaté à base de SiO₂), l'élément intermédiaire 5 est formé par un nitrure de niobium ou de hafnium ou de zirconium directement formé/déposé sur le substrat 2. En outre, le métal de transition formé par le niobium est préféré car il a été constaté que ce dernier permettait une meilleure évacuation des charges lors du fonctionnement du dispositif optoélectronique.

Il a été décrit ci-avant la possibilité que l'élément intermédiaire 5 forme une couche commune à une pluralité de fils 4, notamment s'étendant à partir de cette couche, ou un plot associé à un unique fil 4.

L'élément intermédiaire 5 peut être réalisé à partir de tout type de technique de dépôt. En outre, grâce au métal de transition utilisé, il a l'avantage de présenter un gap plus faible que les couches de nucléation à base d'AIN très utilisées à ce jour comme couche de nucléation.

Selon un premier mode de réalisation l'élément intermédiaire 5 est déposé en phase vapeur à partir d'un mélange gazeux comprenant de l'azote et un métal de transition choisi parmi le titane, le vanadium, le chrome, le zirconium, le niobium, le molybdène, le hafnium, le tantale, ou une combinaison de ces derniers. Notamment le dépôt de l'élément intermédiaire 5 est réalisé à une température comprise entre la température ambiante et 400°C. On obtient ainsi, après ce dépôt, directement la surface destinée à la croissance du fil 4. Autrement dit, lorsque l'élément intermédiaire 5 est formé par un nitrure d'un métal de transition, l'étape de formation de l'élément intermédiaire 5 comporte préférentiellement une étape de dépôt dudit élément intermédiaire 5 à partir d'un mélange gazeux comprenant de l'azote et le métal de transition.

Selon un deuxième mode de réalisation, l'élément intermédiaire 5 est formé à partir des étapes suivantes : le dépôt, notamment sur le substrat 2 ou sur une couche d'oxyde transparent conducteur formée sur le substrat 2, d'une couche d'un métal de transition choisi parmi le titane, le vanadium, le chrome, le zirconium, le niobium, le molybdène, le hafnium, ou le tantale ; et la nitruration d'au moins une partie de la couche de métal de transition déposée de sorte à former l'élément intermédiaire 5 en nitrure de métal de transition présentant une surface 5a destinée à la croissance du fil 4. De préférence, le dépôt de la couche de métal de transition est réalisé à une température comprise entre la température ambiante et 400°C. Le dépôt de la couche de métal de transition peut être réalisé par PVD (dépôt physique par phase vapeur) à partir d'une cible métallique, par exemple une pulvérisation à courant continu parcourant la cible (par exemple le courant I parcourant la cible peut être de 400mA sur une cible de niobium de pureté à 99,95 pendant 45s pour déposer environ 9 nm de Nb, 18s pour déposer 5 nm de Nb et 9s pour déposer 3 nm de Nb). Au cours de cette étape de dépôt du métal de transition, le substrat 2 peut être maintenu à température ambiante.

De manière générale applicable à toute la description par « température ambiante », on entend une température de préférence comprise entre 20°C et 50°C.

La pression dans l'enceinte PVD durant le dépôt du métal de transition peut être comprise entre 3.10⁻³ mbar et 6.10⁻³ mbar.

Après différents tests, il a été possible d'observer que la croissance du ou des fils était favorisée par cet élément intermédiaire 5 formé en deux étapes, on comprend donc que ce deuxième mode est préféré.

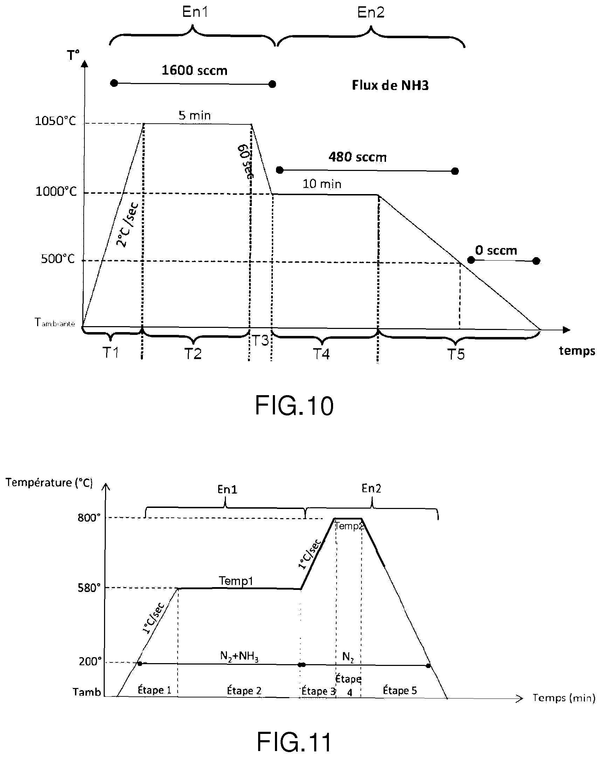

Selon une première mise en oeuvre particulière du deuxième mode de réalisation, notamment illustrée à la figure 10, l'étape de nitruration peut comporter une première sous-étape de nitruration En1 réalisée au moins en partie à une première température en imposant une injection d'un gaz de nitruration selon un premier débit, et une deuxième sous-étape de nitruration En2 réalisée au moins en partie à une deuxième température inférieure ou égale à la première température en imposant une injection du gaz de nitruration selon un deuxième débit distinct (ou non, c'est-à-dire que le premier débit peut être égal au deuxième débit) du premier débit. Ceci permet d'optimiser l'orientation cristallographique de l'élément intermédiaire 5. Il va de soi que ces deux sous-étapes de nitruration sont réalisées l'une après l'autre avec ou sans intercalation d'une phase où l'injection de gaz est stoppée. En particulier, la première sous-étape En1 permet de réaliser une nitruration rapide et la deuxième sous-étape En2 permet de réaliser un recuit stabilisant la phase de nitrure du métal de transition. Consécutivement à ces deux sous-étapes En1 et En2, la couche de métal de transition nitruré est chimiquement et thermiquement stable.

Le gaz injecté peut être de l'ammoniac (NH₃) et/ou du diazote (N₂). Le NH₃ est préféré car il permet de nitrurer plus rapidement la couche de métal de transition. En fait, sous la forme NH₃, le pouvoir nitrurant est plus important que pour le N₂.

Selon un exemple particulier de la première mise en oeuvre particulière du deuxième mode de réalisation, le gaz de nitruration injecté étant de l'ammoniac, la première température est comprise entre 1000°C et 1050°C, notamment égale à 1050°C, le premier débit est compris entre 500 sccm et 2500 sccm (sccm est une unité de débit issue de l'anglais « standard cubic centimeters per minute », soit des centimètres cube par minute), notamment égal à 1600sccm, la deuxième température est comprise entre 950°C et 1050°C, notamment égale à 1000°C, le deuxième débit est compris entre 500 sccm et 2500 sccm, notamment égal à 500 sccm.

Les débits mentionnés ci-dessus correspondent à la capacité volumique de l'enceinte nitruration utilisée, soit un volume total de gaz (par exemple N₂+NH₃) de 8 litres dans l'exemple mentionné. Pour une enceinte de volume différent, les débits devront être adaptés (par exemple : pour une enceinte de 18 litres, le premier débit devra être notamment égal à 4000 sccm et le deuxième débit notamment égal à 1200 sccm). Autrement dit, le premier débit est compris entre 500*V/8 sccm et 2500*V/8 sccm, notamment égal à 1600*V/8 sccm, et le deuxième débit est compris entre 500*V/8 sccm et 2500*V/8 sccm, notamment égal à 500*V/8 sccm. V est la capacité totale en litre d'une enceinte de nitruration correspondante.

Dans la présente description, par « enceinte de nitruration correspondante », on entend l'enceinte dans laquelle la nitruration de la couche de métal de transition est réalisée.

La figure 10 illustre de manière détaillée l'étape de nitruration en représentant l'évolution de la température en fonction du temps dans l'enceinte de nitruration (d'un volume de 8 litres dans l'exemple). Dans un premier temps T1, la température dans l'enceinte de nitruration monte progressivement, par exemple de 2°C/s jusqu'à atteindre un pallier 1050°C. La première sous-étape de nitruration sous NH₃ En1 visée ci-dessus commence lorsque la température atteint 200°C. Au cours de cette première sous étape, le débit de NH₃ reste constant à 1600 sccm. Dans un deuxième temps T2, concomitant à au moins une partie de la première sous-étape, la température est maintenue à 1050°C pendant un temps compris entre 5 minutes et 15 minutes (5 minutes dans l'exemple). Dans un troisième temps T3, la première sous-étape En1 est continuée alors que la température passe de 1050°C à 1000°C en 60s. Dans un quatrième temps T4, la température dans l'enceinte de nitruration est maintenue à 1000°C pendant un temps compris entre 5 minutes et 15 minutes (10 minutes dans l'exemple), et la deuxième sous-étape En2 est débutée. Dans un cinquième temps T5, l'apport de calories dans l'enceinte de nitruration est stoppé de sorte que l'enceinte de nitruration redescende en température jusqu'à revenir à la température ambiante. La durée de T5 peut correspondre à l'inertie de l'enceinte de nitruration. La deuxième sous-étape de nitruration peut être continuée pendant un temps déterminé au cours du cinquième temps T5. Le cinquième temps T5 peut correspondre à un arrêt du chauffage de l'enceinte puis à sa redescente en température ou peut également correspondre à une étape de croissance du ou des fils si l'enceinte utilisée pour la nitruration est aussi l'enceinte de MOCVD (pour dépôt chimique en phase vapeur de métal organique) dédiée à la synthèse du ou des fils.

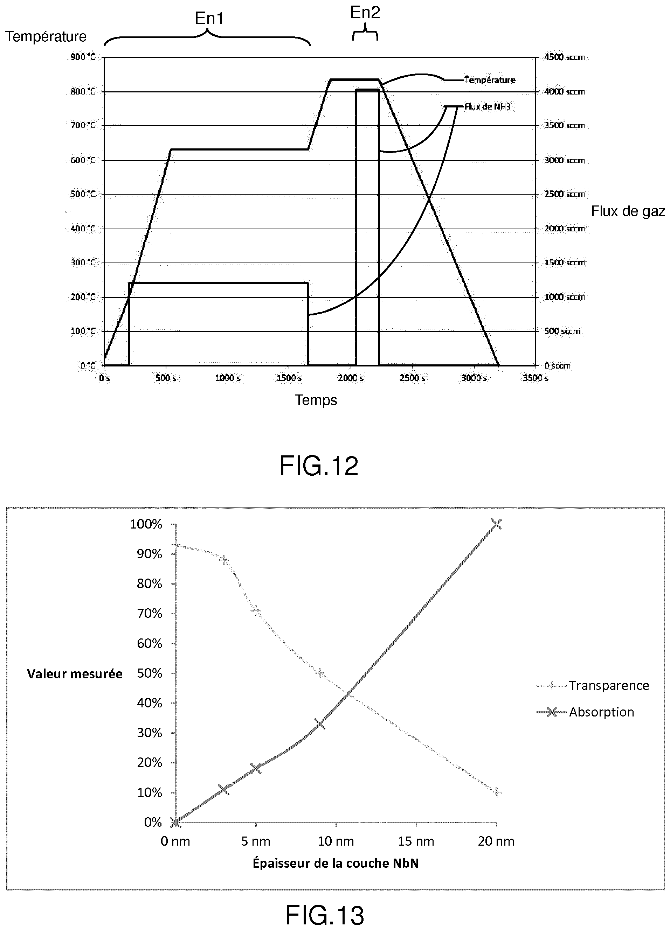

Selon une deuxième mise en oeuvre particulière illustrée aux figures 11 et 12, l'étape de nitruration comporte une première sous-étape de nitruration En1 réalisée au moins en partie à une première température en imposant une injection d'un gaz de nitruration selon un premier débit, une deuxième sous-étape de nitruration En2 réalisée au moins en partie à une deuxième température supérieure ou égale à la première température en imposant une injection du gaz de nitruration selon un deuxième débit distinct, ou non (c'est-à-dire que le premier débit peut être égal au deuxième débit), du premier débit.

En particulier, dans cette deuxième mise en oeuvre du mode de réalisation le gaz injecté est de l'ammoniac et la première température est comprise entre 400°C et 1400°C, le premier débit est compris entre 10*V/18 sccm et 4000*V/18 sccm, notamment égal à 1200*V/18 sccm, la deuxième température est comprise entre 400°C et 1400°C, le deuxième débit est compris entre 10*V/18 sccm et 4000*V/18 sccm, notamment égal à 1200*V/18 sccm, où V est la capacité totale en litre d'une enceinte de nitruration correspondante.

Sur la figure 11, la température Temp1 est comprise entre 400°C et 1050°C (ou 1400°C), notamment entre 500°C et 800°C, et de façon préférentielle égale à 600°C.

La première sous-étape En1 est découpée par souci de clarté en deux étapes : étape 1 et étape 2.

Dans l'étape 1 de la figure 11, on observe une montée en température jusqu'à Temp1 (c'est-à-dire la première température). Les gaz porteurs sont N₂, N₂+H₂, ou H₂, de façon préférentielle N₂. Le gaz de nitruration injecté peut être de l'ammoniac (NH₃) et l'injection peut commencer pour une température comprise entre Tamb (représentative de la température ambiante) et Temp1 ; notamment dès 200°C. La rampe de montée en température de Tamb jusqu'à Temp1 est supérieure à 1°C/min, et notamment égale à 1°C/sec. Au cours de cette étape 1, le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

Dans l'étape 2 de la figure 11, il est réalisé un recuit à Temp1. Les gaz porteurs sont N₂, N₂+H₂, ou H₂, de façon préférentielle N₂. Le gaz de nitruration injecté peut être de l'ammoniac (NH₃). Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. De préférence, le temps de recuit sous NH₃ supérieur à 1 seconde, notamment compris entre 5 minutes et 30 minutes.

La deuxième sous-étape En2 est découpée par souci de clarté en trois étapes : étape 3, étape 4 et étape 5. De préférence, la deuxième température Temp2 est comprise entre 400°C et 1050°C (ou 1400°C), notamment entre 500°C et 1000°C, et de façon préférentielle égale à 800°C. A l'étape 3 (si Temp1≠Temp2, sinon on passe directement à l'étape 4) on a une montée en température jusqu'à Temp2. Les gaz porteurs sont N₂, N₂+H₂, ou H₂, de façon préférentielle N₂. Le gaz de nitruration injecté peut être de l'ammoniac (NH₃). La rampe de montée en température de Temp1 jusqu'à Temp2 est supérieure à 1°C/min et notamment égale à 1°C/sec. Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

A l'étape 4, il est effectué un recuit à Temp2. Les gaz porteurs sont N₂, N₂+H₂, ou H₂, de façon préférentielle N₂. Le gaz de nitruration injecté peut être de l'ammoniac (NH₃). Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. Le temps de recuit sous NH₃ est supérieur à 1 seconde, notamment compris entre 1 et 30 minutes.

A l'étape 5, on effectue une redescente en température. Les gaz porteurs sont N₂, N₂+H₂, ou H₂, de façon préférentielle N₂. Le gaz de nitruration injecté peut être de l'ammoniac (NH₃). La rampe de descente en température de Temp2 jusqu'à Tamb est supérieure à 1°C/min et notamment égale à 1°C/sec. Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

Selon un exemple très particulier illustré en figure 12, la nitruration du métal de transition, préférentiellement du niobium, déposé sur le substrat, notamment en verre d'oxyde (notamment en verre silicaté à base de SiO₂), est idéale lorsque l'on réalise les étapes successives suivantes dans une enceinte de nitruration appropriée (ici d'un volume de 18 litres dans l'exemple) dans laquelle est placé le substrat sur lequel est formé une couche du métal de transition (en pleine plaque ou sous forme d'îlots/plots) :
- une première montée en température jusqu'à 200°C sous un flux d'azote N2 de 20000sccm sous une pression de l'enceinte de nitruration de 100mbar,
- une deuxième montée en température jusqu'à 630°C réalisée dans la continuité de la première montée en température à 1.25°C/s sous un flux de mélange gazeux azote et ammoniac avec un débit de 1400sccm de NH3 et un débit de 18600 sccm de N2 sous une pression de l'enceinte de nitruration de 100mbar,

- le maintient à la température de 630°C pendant 900s sous un flux de mélange gazeux azote et ammoniac avec un débit de 1400sccm de NH3 et un débit de 18600 sccm de N2 sous une pression de l'enceinte de nitruration de 100mbar,
- un troisième montée en température jusqu'à 830°C sous un flux gazeux d'un débit de 20000sccm de N2 à une pression de l'enceinte de nitruration de 100mbar,
- le maintient à la température de 830°C pendant 210s sous un flux gazeux d'un débit de 20000sccm de N2 à une pression de nitruration de 100mbar,
- le maintient à la température de 830°C pendant 185s sous un flux de mélange gazeux azote et ammoniac avec un débit de 4000sccm de NH3 et un débit de 16000 sccm de N2 sous une pression de l'enceinte de nitruration de 400mbar.

Enfin, préférentiellement une étape de redescente en température est réalisée sous un flux gazeux de 20000sccm de N2 sous une pression de l'enceinte de nitruration de 400mbar.

Avantageusement, la croissance du fil est réalisée avant l'étape de redescente en température. Le fil peut alors être en GaN formé par MOCVD.

Selon le processus de la figure 12, on obtient un résultat très satisfaisant, notamment pour le niobium en tant que métal de transition. La figure 13 illustre, pour un élément intermédiaire 5 réalisé en nitrure de niobium selon la mise en oeuvre de l'exemple particulier de la figure 12 des mesures de transmission et d'absorption en fonction de l'épaisseur de l'élément intermédiaire 5. On s'aperçoit donc qu'en dessous de 9nm on obtient allègrement une transmission supérieure à 50% pour une lumière de longueur d'onde à 450nm. En particulier, cette figure 13 permet de mettre en avant que pour une épaisseur de 3nm de l'élément intermédiaire 5 la transparence est de 88% et que pour une épaisseur de 5nm de l'élément intermédiaire la transparence est de 71%.

Les étapes associées à la figure 10 sont préférablement mises en oeuvre lorsque le métal de transition est le Ta (dans ce cas la première température est préférentiellement supérieure à la deuxième température lors de l'étape de nitruration). En effet, pour ce matériau on obtient une amélioration notable de la qualité des fils obtenus (verticalité, homogénéité de forme) par rapport à la mise en oeuvre de la figure 11. Inversement, et pour les même raisons, la mise en oeuvre de la figure 11 s'applique tout particulièrement lorsque l'on cherche à nitrurer le métal de transition de type : Zr, Hf, Nb (dans ce cas la première température est préférentiellement inférieure à la deuxième température lors de l'étape de nitruration).

Dans les différentes réalisations ci-dessus, l'étape de nitruration est avantageusement réalisée dans une enceinte de nitruration placée à une pression comprise entre 50 mbar et 800 mbar, notamment 100 mbar.

En outre, l'étape de croissance du ou des fils peut être réalisée après la deuxième sous-étape de nitruration En2, ou est initiée au cours de la deuxième sous-étape de nitruration En2.

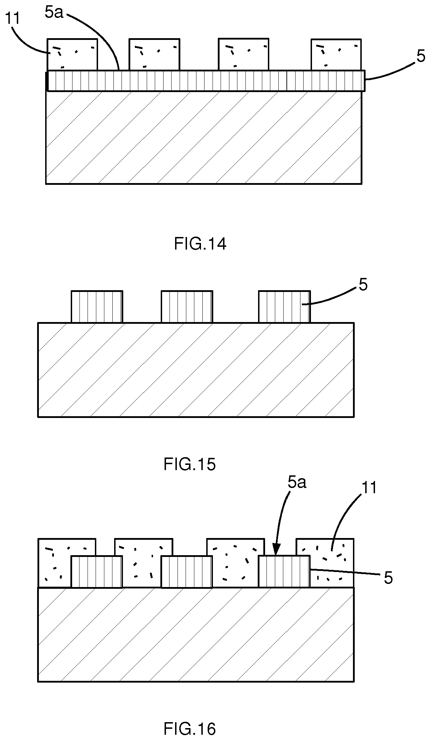

Selon un perfectionnement, on va chercher à localiser en un point donné une zone de croissance du fil 4. En ce sens, comme illustré en figure 14, l'étape de formation de l'organe émetteur de lumière comporte une étape de formation d'un masque 11 délimitant au moins une surface particulière 5a de l'élément intermédiaire 5 destinée à la croissance du fil.

Dans le cas où l'on souhaite faire croître simultanément une pluralité de fils, il est possible d'utiliser un élément intermédiaire 5 se présentant sous la forme d'une couche continue commune à tous les fils en formant sur ladite couche continue commune le masque 11 de telle manière à ce qu'il présente une pluralité d'ouvertures délimitant chacune une surface de croissance 5a, correspondant à une portion de la surface de ladite couche continue commune, d'un fil correspondant (figure 14).

Alternativement, dans la réalisation où chaque fil est associé à un élément intermédiaire 5 sous forme de plot, le procédé peut comporter une étape de formation d'une pluralité de plots formant chacun un élément intermédiaire 5 (figure 15), par exemple par gravure d'une couche initiale de sorte à délimiter chaque plot. Ensuite, le masque 11 peut être formé de telle sorte à délimiter, au niveau de chaque plot 5, une surface de croissance 5a d'un fil correspondant (figure 16).

Le masque peut être formé par du SiN ou du SiO₂.

L'étape de croissance du fil 4 comporte avantageusement une étape d'injection de Ga de sorte à le former en nitrure de gallium, ledit fil 4 s'étendant à partir de la surface de croissance 5a correspondante.

Il résulte de tout ce qui a été dit avant que l'utilisation de l'élément intermédiaire 5 tel que décrit permet à la fois de :
- présenter une structure cristalline compatible avec celle du matériau semi-conducteur formant le fil de sorte à favoriser une croissance adaptée de ce dernier,
- assurer une transparence à la lumière émise permettant d'augmenter la quantité de photons restitués,
- assurer une conductivité électrique adaptée à l'injection de porteurs de charge dans le fil.

De manière générale applicable à tout ce qui a été dit ci-dessus, le substrat sera préférentiellement tel qu'il comporte une stabilité thermique permettant l'épitaxie de nanofils ou microfils, qui se déroule aux alentours de 1000°C.

## Revendications

1. Dispositif optoélectronique (1) comprenant un substrat (2), un organe émetteur (3) de lumière comportant un élément allongé (4) dans une direction formant un angle avec le substrat (2), un élément intermédiaire (5) interposé entre le substrat (2) et une extrémité longitudinale de l'élément allongé (4) la plus proche du substrat (2), dans lequel le substrat (2) est transparent à ladite lumière, **caractérisé en ce que**:
- l'élément intermédiaire (5), transparent à ladite lumière, comporte au moins un nitrure d'un métal de transition, et présente une épaisseur inférieure ou égale à 9nm.

2. Dispositif selon la revendication précédente, **caractérisé en ce que** le substrat (2) est électriquement isolant et/ou **en ce que** l'élément intermédiaire (5) est configuré de sorte à participer à l'injection de porteurs de charge dans l'élément allongé (4) en vue d'émettre ladite lumière.

3. Dispositif selon l'une des revendications précédentes, **caractérisé en ce que** le métal de transition est choisi parmi : le titane, le vanadium, le chrome, le zirconium, le niobium, molybdène, l'hafnium, le tantale, ou une combinaison de ces derniers et/ou **en ce que** le substrat (2) est en verre d'oxyde, notamment en verre silicaté à base de SiO₂.

4. Dispositif selon l'une quelconque des revendications précédentes, **caractérisé en ce qu'**il comporte une zone de restitution (7) de ladite lumière et un miroir (6) agencé de manière à orienter au moins une partie de ladite lumière issue de l'organe émetteur de lumière (3) en direction de ladite zone de restitution (7).

5. Dispositif selon l'une quelconque des revendications précédentes, **caractérisé en ce qu'**il comporte une pluralité d'organes émetteurs de lumière (3) comportant chacun un élément allongé (4), et **en ce que** l'élément intermédiaire (5) forme une couche commune associée à chacun des éléments allongés (4), ou **en ce que** chacun des éléments allongés (4) est associé à un élément intermédiaire (5) correspondant, se présentant sous la forme d'un plot, qui lui est propre.

6. Procédé de fabrication d'un dispositif optoélectronique selon l'une quelconque des revendications précédentes, **caractérisé en ce qu'**il comporte les étapes suivantes :
- une fourniture du substrat (2) transparent à ladite lumière,
- une formation de l'élément intermédiaire (5) de telle sorte à ce qu'il soit transparent à ladite lumière et qu'il présente une surface de croissance (5a) de l'élément allongé (4), l'élément intermédiaire (5) comportant au moins un nitrure d'un métal de transition et présentant une épaisseur inférieure ou égale à 9nm,
- une formation de l'organe émetteur (3) de lumière comprenant une étape de croissance de l'élément allongé (4) à partir de la surface de croissance (5a).

7. Procédé selon la revendication précédente, **caractérisé en ce que** ledit élément intermédiaire (5) étant formé par un nitrure d'un métal de transition, l'étape de formation de l'élément intermédiaire (5) comporte une étape de dépôt dudit élément intermédiaire (5) à partir d'un mélange gazeux comprenant de l'azote et le métal de transition.

8. Procédé selon la revendication 6, **caractérisé en ce que** l'étape de formation de l'élément intermédiaire (5) comporte :
- une étape de dépôt, notamment sur le substrat (2) ou sur une couche d'un oxyde transparent conducteur formée sur le substrat (2), d'une couche du métal de transition, notamment choisi parmi Ti, V, Cr, Zr, Nb, Mo, Hf, Ta,
- une étape de nitruration d'au moins une partie de la couche de métal de transition.

9. Procédé selon la revendication précédente, **caractérisé en ce que** l'étape de nitruration comporte :
- une première sous-étape de nitruration (En1) réalisée au moins en partie à une première température en imposant une injection d'un gaz de nitruration selon un premier débit,
- une deuxième sous-étape de nitruration (En2) réalisée au moins en partie à une deuxième température inférieure ou égale à la première température en imposant une injection du gaz de nitruration selon un deuxième débit distinct, ou non, du premier débit.

10. Procédé selon la revendication précédente, **caractérisé en ce que** le gaz de nitruration injecté est de l'ammoniac, et **en ce que** :
- la première température est comprise entre 1000°C et 1050°C, notamment égale à 1050°C,
- le premier débit est compris entre 500*V/8 sccm et 2500*V/8 sccm, notamment égal à 1600*V/8sccm,
- la deuxième température est comprise entre 950°C et 1050°C, notamment égale à 1000°C,
- le deuxième débit est compris entre 500*V/8 sccm et 2500*V/8 sccm, notamment égal à 500*V/8 sccm
où V est la capacité totale en litre d'une enceinte de nitruration correspondante.

11. Procédé selon la revendication 8, **caractérisé en ce que** l'étape de nitruration comporte :
- une première sous-étape de nitruration (En1) réalisée au moins en partie à une première température en imposant une injection d'un gaz de nitruration selon un premier débit,
- une deuxième sous-étape de nitruration (En2) réalisée au moins en partie à une deuxième température supérieure ou égale à la première température en imposant une injection du gaz de nitruration selon un deuxième débit distinct, ou non, du premier débit.

12. Procédé selon la revendication précédente, **caractérisé en ce que** le gaz de nitruration injecté est de l'ammoniac, et **en ce que** :
- la première température est comprise entre 400°C et 1400°C,
- le premier débit est compris entre 10*V/18 sccm et 4000*V/18 sccm, notamment égal à 1200*V/18 sccm,
- la deuxième température est comprise entre 400°C et 1400°C,
- le deuxième débit est compris entre 10*V/18 sccm et 4000*V/18 sccm, notamment égal à 1200*V/18 sccm
où V est la capacité totale en litre d'une enceinte de nitruration correspondante.

13. Procédé selon l'une des revendications 8 à 12, **caractérisé en ce que** l'étape de nitruration est réalisée dans une enceinte de nitruration placée à une pression comprise entre 50 mbar et 800 mbar, notamment 100 mbar.

14. Procédé selon l'une des revendications 8 à 13, **caractérisé en ce que** l'étape de croissance de l'élément allongé est réalisée après la deuxième sous-étape de nitruration, ou est initiée au cours de la deuxième sous-étape de nitruration.

15. Procédé selon l'une quelconque des revendications 6 à 14, **caractérisé en ce que** l'étape de croissance de l'élément allongé (4) comporte une étape d'injection de Ga de sorte à le former en nitrure de gallium, ledit élément allongé (4) s'étendant à partir de la surface de croissance (5a) correspondante.

## Patentansprüche

1. Optoelektronische Vorrichtung (1), umfassend ein Substrat (2), ein Lichtemitterorgan (3), umfassend ein längliches Element (4) in einer Richtung, die einen Winkel mit dem Substrat (2) bildet, ein Zwischenelement (5), das zwischen dem Substrat (2) und einem longitudinalen Ende des länglichen Elements (4) am nächsten zum Substrat (2) angeordnet ist, wobei das Substrat (2) für das Licht durchlässig ist,
- **dadurch gekennzeichnet, dass** das Zwischenelement (5), das für das Licht durchlässig ist, mindestens ein Übergangsmetallnitrid umfasst und eine Dicke kleiner oder gleich 9 nm aufweist.

2. Vorrichtung nach dem vorhergehenden Anspruch,
**dadurch gekennzeichnet, dass** das Substrat (2) elektrisch isolierend ist, und/oder dadurch, dass das Zwischenelement (5) ausgelegt ist, an der Injektion von Ladungsträgern in das längliche Element (4) zur Emission des Lichts teilzunehmen.

3. Vorrichtung nach einem der vorhergehenden Ansprüche,
**dadurch gekennzeichnet, dass** das Übergangsmetall ausgewählt ist aus: Titan, Vanadium, Chrom, Zirconium, Niob, Molybdän, Hafnium, Tantal oder einer Kombination dieser Letzteren, und/oder dadurch, dass das Substrat (2) aus Oxidglas, insbesondere aus Silikatglas auf der Basis von SiO₂, besteht.

4. Vorrichtung nach einem der vorhergehenden Ansprüche,
**dadurch gekennzeichnet, dass** sie eine Rückführungszone (7) des Lichts und einen Spiegel (6) umfasst, der eingerichtet ist, mindestens einen Teil des Lichts, das von dem Lichtemitterorgan (3) ausgegeben wird, in die Richtung der Rückführungszone (7) zu richten.

5. Vorrichtung nach einem der vorhergehenden Ansprüche,
**dadurch gekennzeichnet, dass** sie mehrere Lichtemitterorgane (3) umfasst, die jeweils ein längliches Element (4) umfassen, und dadurch, dass das Zwischenelement (5) eine gemeinsame Schicht bildet, die mit jedem der länglichen Elemente (4) assoziiert ist, oder dadurch, dass jedes der länglichen Elemente (4) mit einem entsprechenden Zwischenelement (5) assoziiert ist, welches sich in der Form eines Kontaktstücks präsentiert, das zu diesem gehört.

6. Verfahren zur Herstellung einer optoelektronischen Vorrichtung nach einem der vorhergehenden Ansprüche,
**dadurch gekennzeichnet, dass** es die folgenden Schritte umfasst:
- Bereitstellen des Substrats (2), das für das Licht durchlässig ist,
- Bilden des Zwischenelements (5) derart, dass dieses für das Licht durchlässig ist und dass dieses eine Wachstumsfläche (5a) des länglichen Elements (4) aufweist, wobei das Zwischenelement (5) mindestens ein Übergangsmetallnitrid umfasst und eine Dicke kleiner oder gleich 9 nm aufweist,
- Bilden des Lichtemitterorgans (3), umfassend einen Wachstumsschritt des länglichen Elements (4) aus der Wachstumsfläche (5a).

7. Verfahren nach dem vorhergehenden Anspruch,
**dadurch gekennzeichnet, dass**, da das Zwischenelement (5) aus einem Übergangsmetallnitrid gebildet wird, der Schritt des Bildens des Zwischenelements (5) einen Schritt des Abscheidens des Zwischenelements (5) aus einer Gasmischung umfasst, die Stickstoff und das Übergangsmetall umfasst.

8. Verfahren nach Anspruch 6,
**dadurch gekennzeichnet, dass** der Schritt des Bildens des Zwischenelements (5) umfasst:
- einen Schritt des Abscheidens, insbesondere auf dem Substrat (2) oder auf einer leitenden transparenten Oxidschicht, die auf dem Substrat (2) gebildet wird, einer Schicht des Übergangsmetalls, insbesondere ausgewählt aus Ti, V, Cr, Zr, Nb, Mo, Hf, Ta,
- einen Schritt des Nitrierens mindestens eines Teils der Schicht des Übergangsmetalls.

9. Verfahren nach dem vorhergehenden Anspruch,
**dadurch gekennzeichnet, dass** der Nitrierungsschritt umfasst:
- einen ersten Nitrierungsteilschritt (En1), der mindestens teilweise bei einer ersten Temperatur durch Injektion eines Nitrierungsgases mit einem ersten Durchsatz durchgeführt wird,
- einen zweiten Nitrierungsteilschritt (En2), der mindestens teilweise bei einer zweiten Temperatur kleiner oder gleich der ersten Temperatur durch Injektion eines Nitrierungsgases mit einem zweiten Durchsatz durchgeführt wird, der vom ersten Durchsatz verschieden ist oder nicht.

10. Verfahren nach dem vorhergehenden Anspruch,
**dadurch gekennzeichnet, dass** das injizierte Nitrierungsgas Ammoniak ist, und dadurch, dass:
- die erste Temperatur zwischen 1000°C und 1050°C, insbesondere gleich 1050°C, beträgt,
- der erste Durchsatz zwischen 500*V/8 sccm und 2500*V/8 sccm, insbesondere gleich 1600*V/8 sccm, beträgt,
- die zweite Temperatur zwischen 950°C und 1050°C, insbesondere gleich 1000°C, beträgt,
- der zweite Durchsatz zwischen 500*V/8 sccm und 2500*V/8 sccm, insbesondere gleich 500*V/8 sccm, beträgt,
wobei V die Gesamtkapazität in Liter einer entsprechenden Nitrierungshülle ist.

11. Verfahren nach Anspruch 8,
**dadurch gekennzeichnet, dass** der Nitrierungsschritt umfasst:
- einen ersten Nitrierungsteilschritt (En1), der mindestens teilweise bei einer ersten Temperatur durch Injektion eines Nitrierungsgases mit einem ersten Durchsatz durchgeführt wird,
- einen zweiten Nitrierungsteilschritt (En2), der mindestens teilweise bei einer zweiten Temperatur größer oder gleich der ersten Temperatur durch Injektion eines Nitrierungsgases mit einem zweiten Durchsatz durchgeführt wird, der vom ersten Durchsatz verschieden ist oder nicht.

12. Verfahren nach dem vorhergehenden Anspruch,
**dadurch gekennzeichnet, dass** das injizierte Nitrierungsgas Ammoniak ist, und dadurch, dass:
- die erste Temperatur zwischen 400°C und 1400°C beträgt,
- der erste Durchsatz zwischen 10*V/18 sccm und 4000*V/18 sccm, insbesondere gleich 1200*V/18 sccm, beträgt,
- die zweite Temperatur zwischen 400°C und 1400°C beträgt,
- der zweite Durchsatz zwischen 10*V/18 sccm und 4000*V/18 sccm, insbesondere gleich 1200*V/18 sccm, beträgt,
wobei V die Gesamtkapazität in Liter einer entsprechenden Nitrierungshülle ist.

13. Verfahren nach einem der Ansprüche 8 bis 12,
**dadurch gekennzeichnet, dass** der Nitrierungsschritt in einer Nitrierungshülle durchgeführt wird, die unter einen Druck zwischen 50 und 800 mbar, insbesondere 100 mbar, gesetzt wird.

14. Verfahren nach einem der Ansprüche 8 bis 13,
**dadurch gekennzeichnet, dass** der Wachstumsschritt des länglichen Elements nach dem zweiten Nitrierungsteilschritt durchgeführt wird oder im Laufe des zweiten Nitrierungsteilschritts initiiert wird.

15. Verfahren nach einem der Ansprüche 6 bis 14,
**dadurch gekennzeichnet, dass** der Wachstumsschritt des länglichen Elements (4) einen Schritt des Injizierens von Ga umfasst, um Galliumnitrid zu bilden, wobei sich das längliche Element (4) von der entsprechenden Wachstumsoberfläche (5a) erstreckt.

## Claims

1. An optoelectronic device (1) comprising a substrate (2), a light-emitting member (3) comprising an elongate element (4) extending in a direction forming an angle with the substrate (2), an intermediate element (5) interposed between the substrate (2) and a longitudinal end of the elongate element (4) closest to the substrate (2), wherein the substrate (2) is transparent to said light, **characterized in that**:
- the intermediate element (5), transparent to said light, comprises at least one nitride of a transition metal, and has a thickness less than or equal to 9 nm.

2. The device as claimed in the preceding claim, **characterized in that** the substrate (2) is electrically insulating and/or **in that** the intermediate element (5) is configured so as to contribute to the injection of charge carriers into the elongate element (4) with a view to emitting said light.

3. The device as claimed in one of the preceding claims, **characterized in that** the transition metal is chosen from: titanium, vanadium, chromium, zirconium, niobium, molybdenum, hafnium, tantalum, or a combination thereof and/or **in that** the substrate (2) is of oxide glass, notably of SiO₂-based silicate glass.

4. The device as claimed in any one of the preceding claims, **characterized in that** it comprises a zone for restoration (7) of said light and a mirror (6) arranged so as to orient at least a part of said light from the light-emitting member (3) toward said restoration zone (7).

5. The device as claimed in any one of the preceding claims, **characterized in that** it comprises a plurality of light-emitting members (3) each comprising an elongate element (4), and **in that** the intermediate element (5) forms a common layer associated with each of the elongate elements (4), or **in that** each of the elongate elements (4) is associated with a corresponding intermediate element (5), taking the form of a block, which is specific thereto.

6. A method for fabricating an optoelectronic device as claimed in any one of the preceding claims, **characterized in that** it comprises the following steps:
- provision of the substrate (2) transparent to said light,
- formation of the intermediate element (5) such that it is transparent to said light and that it has a growth surface (5a) for the elongate element (4), the intermediate element (5) comprising at least one nitride of a transition metal and having a thickness less than or equal to 9 nm,
- formation of the light-emitting member (3) comprising a step of growth of the elongate element (4) from the growth surface (5a).

7. The method as claimed in the preceding claim, **characterized in that**, said intermediate element (5) being formed by a nitride of a transition metal, the step of formation of the intermediate element (5) comprises a step of deposition of said intermediate element (5) from a gaseous mixture comprising nitrogen and the transition metal.

8. The method as claimed in claim 6, **characterized in that** the step of formation of the intermediate element (5) comprises:
- a step of deposition, notably on the substrate (2) or on a layer of a conductive transparent oxide formed on the substrate (2), of a layer of the transition metal, notably chosen from Ti, V, Cr, Zr, Nb, Mo, Hf, Ta,
- a step of nitriding of at least a part of the layer of transition metal.

9. The method as claimed in the preceding claim, **characterized in that** the nitriding step comprises:
- a first nitriding substep (En1) performed at least partly at a first temperature by enforcing an injection of a nitriding gas according to a first flow rate,
- a second nitriding substep (En2) performed at least partly at a second temperature less than or equal to the first temperature by enforcing an injection of the nitriding gas according to a second flow rate distinct or not from the first flow rate.

10. The method as claimed in the preceding claim, **characterized in that** the nitriding gas injected is ammonia, and **in that**:
- the first temperature lies between 1000°C and 1050°C, notably equal to 1050°C,
- the first flow rate lies between 500*V/8 sccm and 2500*V/8 sccm, notably equal to 1600*V/8 sccm,
- the second temperature lies between 950°C and 1050°C, notably equal to 1000°C,
- the second flow rate lies between 500*V/8 sccm and 2500*V/8 sccm, notably equal to 500*V/8 sccm
where V is the total capacity in liters of a corresponding nitriding chamber.

11. The method as claimed in claim 8, **characterized in that** the nitriding step comprises:
- a first nitriding substep (En1) performed at least partly at a first temperature by enforcing an injection of a nitriding gas according to a first flow rate,
- a second nitriding substep (En2) performed at least partly at a second temperature greater than or equal to the first temperature by enforcing an injection of the nitriding gas according to a second flow rate distinct or not from the first flow rate.

12. The method as claimed in the preceding claim, **characterized in that** the nitriding gas injected is ammonia, and **in that**:
- the first temperature lies between 400°C and 1400°C,
- the first flow rate lies between 10*V/18 sccm and 4000*V/18 sccm, notably equal to 1200*V/18 sccm,
- the second temperature lies between 400°C and 1400°C,
- the second flow rate lies between 10*V/18 sccm and 4000*V/18 sccm, notably equal to 1200*V/18 sccm
where V is the total capacity in liters of a corresponding nitriding chamber.

13. The method as claimed in one of claims 8 to 12, **characterized in that** the nitriding step is performed in a nitriding chamber placed at a pressure of between 50 mbar and 800 mbar, notably 100 mbar.

14. The method as claimed in one of claims 8 to 13, **characterized in that** the step of growth of the elongate element is performed after the second nitriding substep, or is initiated during the second nitriding substep.

15. The method as claimed in any one of claims 6 to 14, **characterized in that** the step of growth of the elongate element (4) comprises a step of injection of Ga so as to form it from gallium nitride, said elongate element (4) extending from the corresponding growth surface (5a).
